(19) Europäisches Patentamt
European Patent Office
Office européen des brevets

(11) **EP 1 872 473 B1**

(12) **EUROPEAN PATENT SPECIFICATION**

(45) Date of publication and mention
of the grant of the patent:
**28.03.2012 Bulletin 2012/13**

(51) Int Cl.:
*H03F 3/217* (2006.01)   *H03F 1/02* (2006.01)

(21) Application number: **06744530.4**

(22) Date of filing: **20.04.2006**

(86) International application number:
**PCT/IB2006/000951**

(87) International publication number:
**WO 2006/111840 (26.10.2006 Gazette 2006/43)**

(54) **A METHOD FOR VOLTAGE MODULATION**

VERFAHREN ZUR SPANNUNGSMODULATION

PROCEDE DE MODULATION DE TENSION

(84) Designated Contracting States:
**AT BE BG CH CY CZ DE DK EE ES FI FR GB GR HU IE IS IT LI LT LU LV MC NL PL PT RO SE SI SK TR**

(30) Priority: **20.04.2005 IT BO20050260**

(43) Date of publication of application:
**02.01.2008 Bulletin 2008/01**

(73) Proprietor: **O.C.E.M. S.P.A.**
**40016 S. Giorgio di Piano (IT)**

(72) Inventor: **RINALDI, Luigi**
**I-07100 Sassari (IT)**

(74) Representative: **Dall'Olio, Giancarlo**
**Invention S.r.l.**
**Via delle Armi 1**
**40137 Bologna (IT)**

(56) References cited:
**EP-A- 0 329 967       EP-A- 0 454 298**
**EP-A- 0 690 560       US-A- 4 831 334**
**US-A1- 2004 109 512**

## Description

### FIELD OF THE INVENTION

The present invention relates to a voltage modulation method for transforming a signal of a limited power, into a signal of substantially the same wave form, but amplified by a given factor, for feeding an electric load.

### DESCRIPTION OF THE PRIOR ART

Known amplifying devices process an input analogic signal and generate an amplified output signal, whose wave form roughly reproduces the wave form of the first one, because it can assume only a definite number of values within a given variation range.

Therefore, the output signal has a waveform that reproduces the input one only on average basis, considering a selected time interval.

This is obtained, in known way, by an analogic-digital conversion of the input signal, which includes, as follows: sampling, quantization and codification of the input signal, e.g. according to a binary code; in this way, a constant codified value, corresponding to the one of the "sample", subtracted by a quantization error, is given to the input signal at each sampling interval.

A logic unit, usually situated before the conversion block, processes the codified signal and activates and deactivates of a well defined plurality of switching units, arranged in series and connected to an electric load, to define an electrically continuous circuit.

Each of the switching units has a supply source and changeover means, whose operation causes connecting and disconnecting of the supply source to the circuit, respectively increasing and decreasing the voltage applied to the load by a value equal to the difference established by the source.

A process similar to the one described above is described in the European Patent no. EP 0 124 765, concerning a digital power switching amplifier.

According to this technical solution, if $U_0$ indicates the maximum voltage, which can be supplied to the load and N defines the number of switching units, the $n^{th}$ switching unit (that is the switching unit which can be recognized by an identifying address "n") can contribute with a voltage equal to the ratio respectively of the just mentioned units ($U_0/N$) and is activated when the voltage on the load must exceed the value expressed by the ratio multiplied by "n" minus one (that is $U_0/N*(n-1)$, with "n" comprised between 1 and N).

Due to the randomness of the generic input signal development, the switching units will be prevailingly in an active configuration ("n" of low value), others prevailingly in an inactive configuration ("n" value close to N), and still others will be activated and deactivated with a high switching frequency, close to the sampling frequency.

Therefore, this determines an unbalanced working of the amplifier, which causes a premature wearing of the switching units, subjected to high switching frequencies and/or working mainly in active configuration, and consequently to a reduced device reliability, with numerous maintenance operations and substitutions of its electronic elements.

The sampling frequency, which as it is known, must be preferably high, is thus limited by the maximum switching frequency, which each stage can stand and, among others, by high heat-power loss, increasing with the increase of the switching frequency.

Moreover, the connection of the filters to the load, typically low pass filters, becomes difficult, because the lower the sampling frequency is, the higher its costs and dimensions are.

The previously cited document EP 0 124 765 and all of documents EP 0 329 967, EP 0 690 560 disclose an apparatus for voltage modulation comprising a plurality of modules connected in a series to establish an overall voltage applied to a load, each of the modules being identified by an identifying code and including at least one supply source and switching means for connecting or disconnecting the supply source, thus activating and deactivating the module, to either increase or decrease respectively the voltage applied to said load by a value equal to the voltage supplied by the supply source, said switching means being controlled by a central unit, according to processing of at least one modulating signal. Another apparatus for voltage modulation is disclosed by document US 2004/109512.

### SUMMARY OF THE INVENTION

The object of the present invention is to propose a method for voltage modulation, which reduces considerably the above mentioned drawbacks; in short, a method, which allows to obtain a balanced and reliable operation of the switching units, thus reaching higher switching frequencies with respect to the ones obtained with known devices and methods.

The above mentioned objects are obtained, in accordance with the claims, by a method for voltage modulation using a plurality of modules connected in a series to establish an overall voltage applied to a load, each of the modules being identified by an identifying code and including at least one supply source and switching means for connecting or disconnecting the supply source, thus activating and deactivating the module, to either increase or decrease respectively the voltage applied to said load by a value equal to the voltage supplied by the supply source, said switching means being controlled by a central unit, according to processing of at least one modulating signal, the method being characterized in that it includes an initializing step for setting to zero a turn-on counter ($I_{ON}$), a turn-off counter ($I_{OFF}$), and an activation variable ($MOD_{ON}$) and in that it continuously repeats time cycles, each of which including:

a) finding the value of said modulating signal and calculating an error variable defined by the multiplication of the value of the modulating signal (m) by the total number of modules (N), from which the number of said active modules, defined by the value of the activation variable, is detracted; and one of the following steps, namely:

b) if said error variable value is bigger than one, or possibly equal to one, a turning on algorithm is executed causing:

i. activation of at least one more of said modules, at a turn-on time, namely a module having an identifying code equal to a number memorized in the turn-on counter;
ii. increase of the turn-on counter by at least one;
iii. increase of said activation variable by a number equal to the number of just turned-on modules;

c) if said error variable value is smaller than minus one, or possibly equal to minus one, a turning off algorithm is executed causing:

i. deactivation of at least one of the active modules, at a turn-off time, namely a module having an identifying code equal to a number memorized in the turn-off counter;

ii. increase of the turn-off counter by at least one;

iii. decrease of said activation variable by a number equal to the number of just turned-off modules;

d) if said error variable value is comprised between minus one and one:

i. activation of said module having identifying code equal to the one memorized in the turn-on counter, when, within a prefixed time cycle, an activation time has passed at least close to a representative duration of the time cycle, multiplied by the difference between one and the value of said error variable divided by two;

ii. deactivation of a module with identifying code equal to the one memorized in the turn-off counter, when a deactivation time has passed, within a prefixed time cycle, at least close to a representative duration of the time cycle, multiplied by the sum of one and the value assumed of said error variable.divided by two;

iii. increase of said turn-on counter and turn-of counter by a value equal to at least one.

## BRIEF DESCRIPTION OF THE DRAWINGS

The characteristic features of the invention, which do not appear from what has been just said, will be better pointed out in the following, in accordance with the claims and with reference to the enclosed figures, in which:

- Figure 1 is a block diagram of a possible system for the voltage modulation, which carries out the proposed method;

- Figure 2 is a flow diagram of the proposed method, in a preferred embodiment;

- Figure 3 shows examples of the in-time behavior of some significant units of Figure 1;

- Figure 4 is a flow diagram of the method according to another embodiment;

- Figure 5 shows examples of the in-time behavior of some significant units of Figure 1, according to this embodiment.

## BEST MODER OF CARRYING OUT THE INTENTION

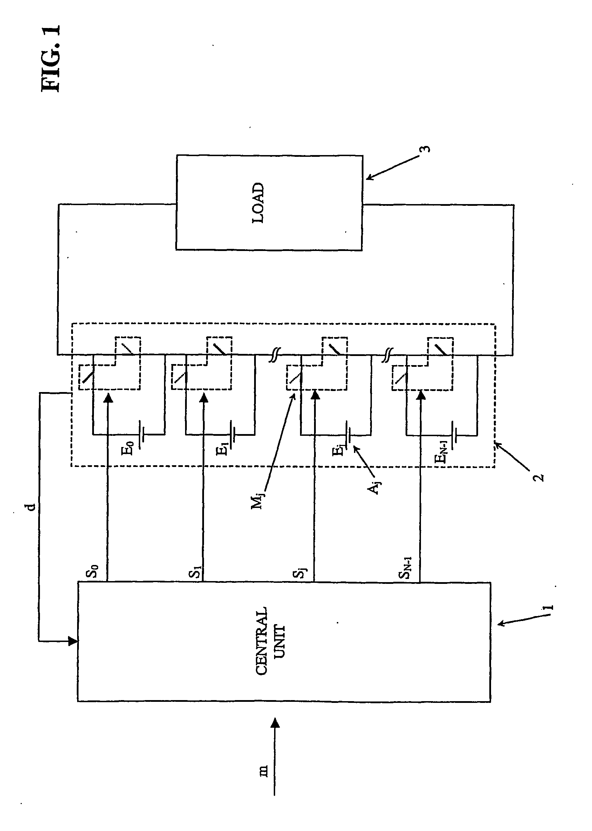

Having regard to the enclosed Figures, the general reference numeral 1 indicates a central unit, which receives an input modulating signal m, e.g. an analogic voltage signal varying between zero and one (with respect to a common ground reference), and supplies a plurality of output signals $S_0$, $S_1$, ... $S_j$,... $S_{n-1}$, aimed at activating and deactivating a plurality of modules 2, present in N units, see Figure 1.

The modules 2 are connected in a series and each of them can be located by an identification code (e.g. numerical and comprised between 0 and N-1).

The modules are electrically connected to a load 3, to define an electrically continuous circuit.

The generic "$j^{th}$" module ("j" code, comprised in the above mentioned interval) includes a supply source $A_j$ and switching means $M_j$, whose operation deactivates or activates the module, with respective decrease or increase of the voltage applied to the load 3, by a value equal to the voltage $E_j$ (with $E_0=E_1=.. =E_j=..=E_{N-1}$), supplied by the source.

For example, in Figure 1, the first module, $j^{th}$ module and N-1$^{th}$ module are in active condition, while the zero module is in deactivated condition.

Still with reference to Figure 1, d indicates schematically a diagnostic signal, which passes from the plurality of module 2 to the central unit 1.

The diagnostic signal d contains information concerning e.g. the correct working of each module.

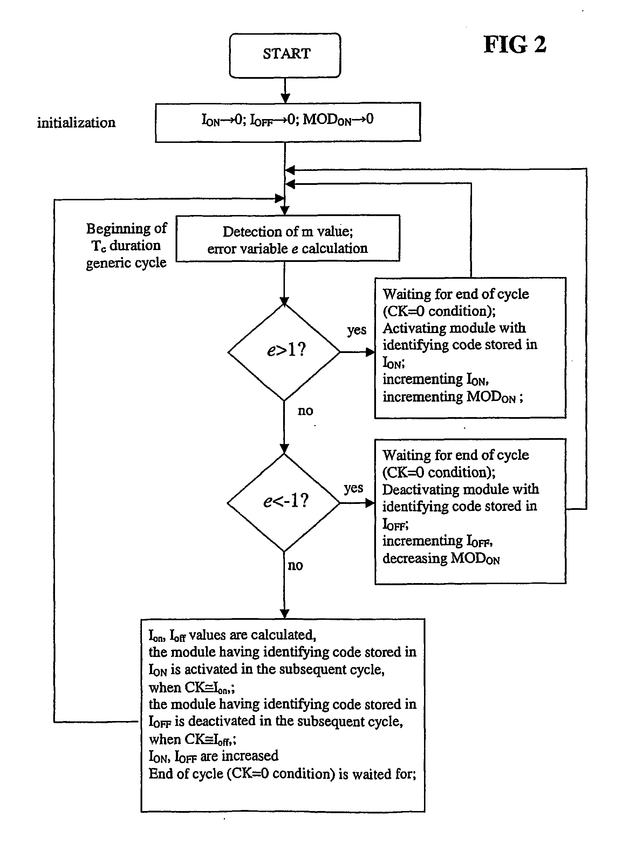

Figure 2 shows a flow diagram (better described later on), which summarizes, with functional blocks, the operations of the proposed method, according to a preferred embodiment.

The flow diagram shows an initialization step, including resetting of a turn-on counter $I_{ON}$ (symbolically: $I_{ON} \rightarrow O$), of a turn-off counter $I_{OFF}$ (both e.g. of loop type, operating between corresponding values 0 and N-n) and an activation variable $MOD_{ON}$ (e.g. implemented by a memory cell), whose value indicates the actual number of the active modules (initially equal to zero).

The method includes a sequence of operations, repeated cyclically, according to a plurality of time cycles of duration $T_C$, with the first time cycle including:

a) finding the value of the modulating signal m and calculating an error variable e defined by the multiplication of the value of the latter by the total number of modules N, from which the value of the activation variable $MOD_{ON}$ is detracted:

$$e = m*N - MOD_{ON}$$

b) if the error variable e value is bigger than one, carrying out a turning on algorithm, which includes: activation of a module, at a turn-on time $T_a$, e.g. coinciding with the beginning of the subsequent time cycle, having the module having identifying code equal to the one memorized in the turn-on counter $I_{ON}$; increase of the latter by a value at least equal to one, as well as increase of said activation variable $MOD_{ON}$ by a unitary value;

c) if the error variable e value is smaller than minus one, carrying out a turning off algorithm, which includes: deactivation of a module, at a turn-off time $T_a$, e.g. coinciding with the beginning of the subsequent time cycle, the module having identifying code equal to the one memorized in the turn-off counter $I_{OFF}$; increase of the latter by a value at least equal to one, as well as decrease of said activation variable $MOD_{ON}$ by a unitary value;

d) if the error variable e value is comprised between minus one and one: calculating a turn-on variable $I_{on}$ (whose value is e.g. memorized in a corresponding memory cell), defined by the multiplication of the difference between one and the value of the error variable per a quantity equal to half resolution value RES,

$$I_{ON} = (1 - e) * RES / 2;$$

calculation of a turn-off variable $I_{off}$ (whose value is e.g. memorized in a corresponding memory cell), defined by the multiplication of the sum of one and the value of the error variable, by a quantity equal to the half resolution value RES,

$$I_{off} = (1 + e) * RES / 2;$$

activation of a module, whose identifying code is equal to the one memorized in the turn-on counter $I_{ON}$, when a time $T_{on}$ has passed, e.g. within a time cycle subsequent to the first one, coinciding with or close to the representative value of the duration $T_c$ of the latter, multiplied by the value of said turn-on variable $I_{on}$, divided by said resolution value RES,

$$T_{on} \cong T_c * I_{on} / RES;$$

deactivation of a module, whose identifying code is equal to the one memorized in the turn-off counter $I_{OFF}$, when a time $T_{off}$ has passed, e.g. within a time cycle subsequent to the first one, coinciding with or close to the representative value of the duration $T_t$ of the latter, multiplied by the value of said turn-off variable $I_{off}$, divided by said resolution value RES,

$$T_{off} \cong T_C * I_{off} / RES;$$

increase of said turn-on $I_{ON}$ and turn-off $I_{OFF}$ counters by a value equal to at least one.

The second time cycle, next to the first one, includes the carrying out of the step a) in combination with the remaining steps b), c), d) and so on for the subsequent time cycles.

The steps b), c), d) are carried out in accordance with the value, calculated during the step a), of the error variable e respectively in cases, in which it has a value bigger than one, smaller then minus one and comprised between minus one and one; otherwise, the steps b), c), d) can be carried out respectively in cases, in which the error variable e has a value:

bigger or equal to one, smaller or equal to minus one, bigger than minus one and smaller than one;

- bigger or equal to one, smaller to minus one, bigger or equal to minus one and smaller than one;

- bigger than one, smaller or equal to minus one, bigger than minus one and smaller or equal to one.

It is specified that, when the step d) occurs, the modules, whose identifying codes are memorized in the turn-on counter $I_{ON}$ and turn-off counter $I_{OFF}$, are respectively activated and deactivated, e.g. when the relevant times $T_{on}$ and $T_{off}$ have integer values, as close to the value calculated with the above expressions, as possible.

It is possible to express this definition in formulae:

$$T_{on} = int (T_C * I_{on} / RES);$$

$$T_{off} = int (T_C * I_{off} / RES),$$

in which the generic function "int (x)", where x is any real number, returns the integer nearest to x; the resolution value RES can be assumed e.g. equal to one.

The so calculated values $T_{on}$ and $T_{off}$ are as close to the values within the brackets of the expression at the right side of the equity sign of the relevant formulae, as the representative number $T_c$ of the duration of each time cycle is high (as obvious):

for example, if the cycle is 1,3 microsecond long, the approximation is smaller if the duration $T_c$ of each time cycle is expressed in pico-seconds rather than in nanoseconds.

Further, the present method can include a loop-type Clock counter, which takes values within the range between zero and resolution value RES (which in this occasion can have even relatively high values), with the beginning of each $T_c$-long time cycle corresponding to zero value.

Thus, the Clock counter scans the times of each time cycle, so that the activation and/or deactivation of one or more modules, in accordance with the carrying out of the steps b), c), d), coincides with the updating of values taken by the counter.

Therefore, in this sense, the steps b) or c) corresponds respectively to the activation and the deactivation of the relative module (on the ground of the previous observations), when the value CK of the Clock counter is equal to zero, that is coincides with the beginning of a new time cycle.

The carrying out of step d) in the subsequent time cycle corresponds to the activation of the module, whose identifying code is memorized in the turn-on counter $I_{ON}$ counter, when the clock counter takes the integer value, nearest to the one taken by the turn-on variable $I_{on}$, e.g.:

$$CK = int (I_{on});$$

likewise, the deactivation of the module, whose identifying code is memorized in the turn-off counter $I_{OFF}$, occurs, always in the time cycle subsequent to the current one, when the Clock counter takes the integer value, nearest to the one taken by the turn-off variable $I_{off}$, e.g. :

$$CK = int (I_{off}).$$

In the light of the above consideration, the flow chart shown in Figure 2 results easy to understand.

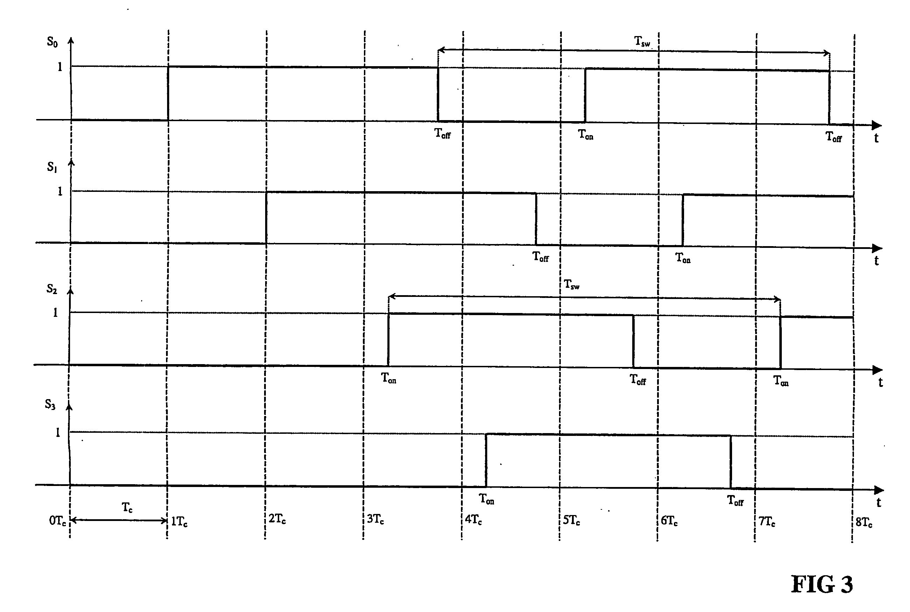

For example, Figure 3 shows schematically the in-time behavior of the control signals $S_0$, $S_1$, $S_2$, $S_3$, supposing that there are four modules (N = 4), that the rise and fall times of each control signal are considered null for sake of clarity, and that a value of the modulating signal m is constant and equal to 0,625; in the chart, the logical value "1" is associated to the activation of the corresponding module, while the logical value "0" is associated to the deactivation of the related module.

At the beginning, (beginning step shown in Figure 2), the turn-on counter $I_{ON}$, the turn-off counter $I_{OFF}$, and the activation variable $MOD_{ON}$ are set to zero; the m value, constant, as it has been said previously, is found and the value of the error variable e is calculated,

$$e = 0,625 * 4 - 0 = 2,5,$$

therefore the step a) is followed by the step b), corresponding to the unitary increase of the turn-on counter $I_{ON}$ and of the activation variable $MOD_{ON}$.

At the beginning of the subsequent time cycle (time $1T_c$ on the chart), when CK = 0, the zero address module is activated and the step a) follows again, with finding of the m value, always supposed to be equal to 0,625, and calculation of the error variable e, which this time takes a value equal to 1,5; this corresponds again to the carrying out of the step b), with the unitary increase of the turn-on counter $I_{ON}$ and of the activation variable $MOD_{ON}$.

At the subsequent time cycle (time $2T_c$ on the chart), when CK = 0, the one address module is activated and the step

a) follows, with the following result:

$$e = 0,625 * 4 - 2 = 0,5,$$

therefore the step d) is carried out, with consequent calculation of the turn-on variable $I_{on}$ and the turn-off variable $I_{off}$; supposing e.g. that RES is equal to 1000, these values are equal respectively to 250 and to 750, therefore, at the subsequent time cycle (comprised between the time $3T_c$ and $4T_c$), the two 2-coded module is activated, when CK = 250, and the zero-coded module is deactivated, when CK = 750.

With times longer than $4T_c$, the step a) and then the step d) are cyclically carried out, as it can be deduced from the analysis of the flow chart of Figure 3.

A squared, variable voltage is applied to the load 3, and its medium value is two times and a half the difference between the voltage $E_j$ (with $E_c = .. = E_j = .. = E_3$), supplied by a generic supply source, and a cycle frequency $f_c$ equal to the reciprocal of the duration $T_c$ of each time cycle, while each module is activated and deactivated periodically supposing that the modulating signal m is constant), with a switching period $T_{sw}$ equal to the product of the duration of each time cycle $T_c$ and the number N of present modules:

$$T_{sw} = T_c * N.$$

The above expression remains approximately valid also for modulating signals m, changing in time.

$$T_{sw} \cong T_c * N.$$

As it is obvious, the switching time $T_{sw}$ decreases with the increase of the number N of present modules, the duration of the time cycles $T_c$ being the same, and consequently, the heat-power losses attributed to each module decrease.

With the same allowed switching frequency $f_{sw}$ (with $f_{sw}$ equal to the reciprocal of the switching period $T_{sw}$), the maximum allowed cycle frequency $f_c$ increases with the increase of the number N of modules, which are used for the implementation of the present method:

$$f_{sw} (max) \cong f_c (max) / N.$$

This way, by using a certain number N of modules, it is possible to reach high cycle frequency $f_c$, which allows to introduce a smaller and less expensive filter on the load 3 (not shown in Figure 1).

This because each time the modulating signal changes, different modules are either activated or deactivated. The changeover frequency is therefore unlinked from the single module changeover time.

Another advantage of the present method lies in the fact that the modules are subjected to nearly identical operation conditions, since each module is "stressed" in the same extent : actually, as it is understood e.g. from the analysis of Figure 3, each module has the same switching frequency $f_{sw}$; this condition, is approximately valid, as it has already been said, also for modulating signals, which are variable anyway, therefore, the time intervals, during which each module remains active, can be considered generally the same.

In this way, a balanced operation of the plurality of modules 2 is obtained, which results in an increased reliability of the system or device, which carries out the proposed method and reduces the maintenance operations to the minimum.

It is also possible that the number N of modules is higher than the number absolutely necessary for the good operation of the system or device, which carries out the proposed method (satisfying e.g. suitable specifics about the value of the switching frequency $f_{sw}$, which must be obtained).

This is particularly useful, when one or more modules of the plurality of modules 2 fail , because it is possible to exclude its/their identifying code/codes from the count performed by the turn-on counter $I_{ON}$ and the turn-off counter $I_{OFF}$.

The information about the modules failure are sent to the central unit 1 through the diagnostic signal d coming from the plurality of modules 2.

This advantage allows a further increase of the reliability of the whole system or device.

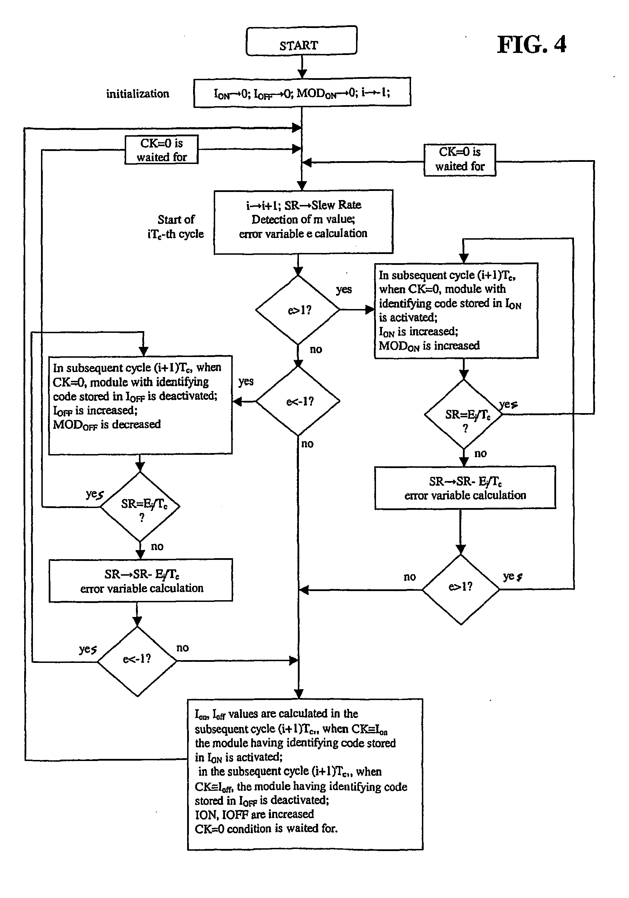

Another variant is shown, as a flow diagram, in Figure 4, and includes, as a particular case, the preferred, above mentioned embodiment: actually, this flow diagram is identical to the one of Figure 2, supposing that the so-called "Slew Rate", defined as the maximum voltage variation in a prefixed time interval, in this case taken equal to the duration of a time cycle $T_c$, coincides with the following expression:

$$Slew\ Rate = E_j / T_c,$$

that is, equal to the ratio of the difference of the potential present on the ends of a generic supply source $A_j$ for the time $T_c$.

In other words, the present method extends and is valid also for the Slew Rate values, which are multiple of the one expressed in the above formula.

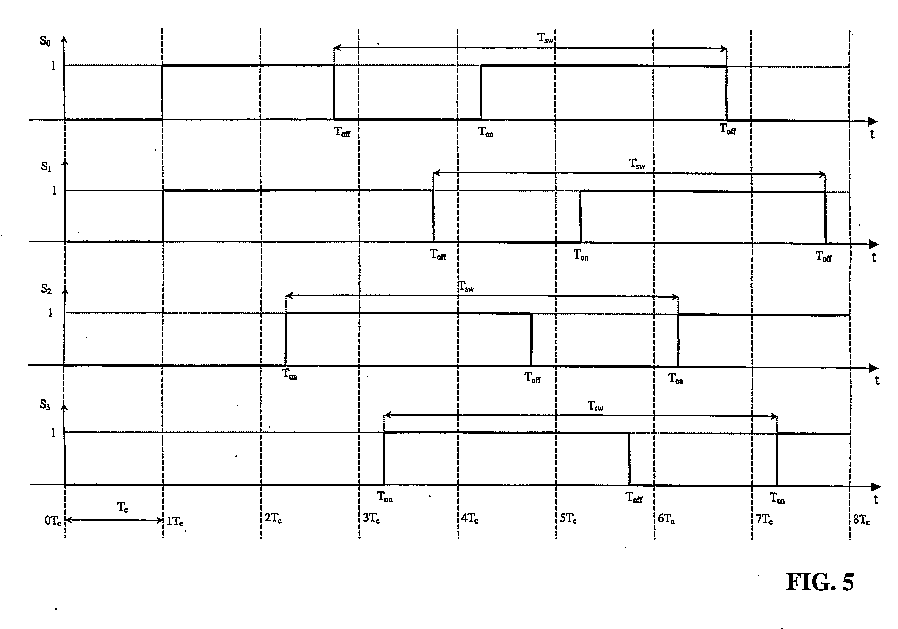

For example, Figure 5 shows the in-time behavior of the control signals $S_0, .. , S_3$, with the same hypotheses made in the introduction to the diagram of Figure 3, applying a Slew Rate equal to:

$$Slew\ Rate = 2 * E_j / T_c.$$

**Claims**

1. A method for voltage modulation using a plurality of modules (2) connected in a series to establish an overall voltage applied to a load (3), each of the modules being identified by an identifying code and including at least one supply source ($A_j$) and switching means ($M_j$) for connecting or disconnecting the supply source, thus activating and deactivating the module, to either increase or decrease respectively the voltage applied to said load (3) by a value equal to the voltage ($E_j$) supplied by the supply source ($A_j$), said switching means ($M_j$) being controlled by a central unit (1), according to processing of at least one modulating signal (m), the method being **characterized in that** it includes an initializing step for setting to zero a turn-on counter ($I_{ON}$), a turn-off counter ($I_{OFF}$), and an activation variable ($MOD_{ON}$) and **in that** it continuously repeats time cycles, each of which including:

a) finding the value of said modulating signal (m) and calculating an error variable (e) defined by the multiplication of the value of the modulating signal (m) by the total number of modules (N), from which the number of said active modules, defined by the value of the activation variable ($MOD_{ON}$), is detracted;
and one of the following steps, namely:

b) if said error variable (e) value is bigger than one, or possibly equal to one, a turning on algorithm is executed causing:

i. activation of at least one more of said modules, at a turn-on time ($T_a$), namely a module having an identifying code equal to a number memorized in the turn-on counter ($I_{ON}$);
ii. increase of the turn-on counter by at least one;
iii. increase of said activation variable ($MOD_{ON}$) by a number equal to the number of just turned-on modules;

c) if said error variable (e) value is smaller than minus one, or possibly equal to minus one, a turning off algorithm is executed causing:

i. deactivation of at least one of the active modules, at a turn-off time ($T_s$), namely a module having an identifying code equal to a number memorized in the turn-off counter ($I_{OFF}$);
ii. increase of the turn-off counter by at least one;
iii. decrease of said activation variable ($MOD_{ON}$) by a number equal to the number of just turned-off modules;

d) if said error variable (e) value is comprised between minus one and one:

i. activation of said module having identifying code equal to the one memorized in the turn-on counter ($I_{ON}$), when, within a prefixed time cycle, an activation time ($T_{on}$) has passed at least close to a representative duration ($T_c$) of the time cycle, multiplied by the difference between one and the value of said error variable divided by two;
ii. deactivation of a module with identifying code equal to the one memorized in the turn-off counter ($I_{OFF}$), when a deactivation time ($T_{off}$) has passed, within a prefixed time cycle, at least close to a representative duration of the time cycle, multiplied by the sum of one and the value assumed of said error variable divided by two;
iii. increase of said turn-on counter ($I_{ON}$) and turn-off counter ($I_{OFF}$) by a value equal to at least one.

2. A method, according to claim 1, including a Clock counter, which cyclically increases its output value starting from a zero value up to a resolution value (RES), with said time cycle starting at said zero value and ending at said resolution value (RES); activation and/or deactivation of at least one of said modules, due to execution of said d) step, occurring at an incremental updating of said Clock at least close to a turn-on variable ($I_{on}$), defined by the multiplication of the difference between one and the value of said error variable by a quantity equal to half said resolution value (RES), and to a turn-off variable ($I_{off}$), defined by the multiplication of the sum of one and the value assumed of said error variable, by a quantity equal to the half resolution value (RES).

3. A method, according to claim 2, wherein after the execution of said step d), a module with an identifying code equal to the one memorized in the turn-on counter ($I_{ON}$) is activated, within a prefixed time cycle, at an activation time ($T_{on}$) equal to an integer closest to a representative duration of the time cycle, multiplied by the value assumed by said turn-on variable ($I_{on}$), divided by said resolution value (RES).

4. A method, according to claim 2, wherein, after the execution of said step d), a module with an identifying code equal to the one memorized in the turn-off counter ($I_{OFF}$) is deactivated, within a prefixed time cycle, at a deactivation time ($T_{off}$) equal to the integer closest to a representative value of the duration of the time cycle, multiplied by the value of said turn-off variable ($I_{off}$), divided by said resolution value (RES).

5. A method, according to claim 1, wherein, after execution of said step b), said error variable (e) is calculated and said steps b), d) are repeated by a number of times according to the value of said error variable (e).

**6.** A method, according to claim 1, wherein, after execution of said step c), said error variable (*e*) is calculated and said steps c), d) are repeated by a number of times according to the value of said error variable (*e*).

**7.** A method, according to claim 1, wherein said turn-on time ($T_a$) is at least near to the beginning of a next time cycle.

**8.** A method, according to claim 1, wherein said turn-off time ($T_s$) is at least near to the beginning of a next time cycle.

**9.** A method, according to claim 1, wherein said turn-on counter ($I_{ON}$) and turn-off counter ($I_{OFF}$) are of loop type, and take values comprised between zero and the number of said plurality of modules (2) diminished by one.

**10.** A method, according to claim 1, including a Clock counter, which cyclically increases the output value starting from zero and up to a value equal to said resolution value (RES), each time cycle beginning at zero value, while activation and deactivation of at least one module, occurring during said steps b), c), d), coincide with updating of value of said Clock counter.

**11.** A method, according to claim 1, wherein at least one given value is excluded from the values assigned to said turn-on counter ($I_{ON}$) and turn-off counter ($I_{OFF}$), during the operation condition, to prevent deactivation or activation of a module having identifying code coinciding with said given value.


**Patentansprüche**

**1.** Verfahren zur Spannungsmodulation, das mehrere Module (2) verwendet, die in Reihe geschaltet sind, um eine Gesamtspannung aufzubauen, die an eine Last (3) angelegt wird, wobei jedes der Module durch einen Erkennungscode gekennzeichnet ist und mindestens eine Versorgungsquelle ($A_j$) und Schaltmittel ($M_j$) beinhaltet, die dazu dienen, die Verbindung mit der Versorgungsquelle herzustellen bzw. zu trennen und somit das Modul zu aktivieren bzw. zu deaktivieren, um die an die Last (3) angelegte Spannung jeweils um einen Wert zu erhöhen bzw. zu verringern, der gleich der Spannung ist ($E_j$), die von der Versorgungsquelle ($A_j$) geliefert wird, wobei diese Schaltmittel ($M_j$) durch eine Zentraleinheit (1) entsprechend der Verarbeitung von mindestens einem Modulationssignal (m) gesteuert werden, wobei das Verfahren **dadurch gekennzeichnet ist, dass** es einen Initialisierungsschritt zur Nullstellung eines Einschaltzählers ($I_{ON}$), eines Ausschaltzählers

($I_{OFF}$) und einer Aktivierungsvariable ($MOD_{ON}$) beinhaltet und dass es kontinuierlich Zeitzyklen wiederholt, welche jeweils Folgendes beinhalten:

a) Ermitteln des Wertes des Modulationssignals (m) und Berechnen einer Fehlervariablen (*e*), die definiert ist durch das Produkt der Multiplikation des Wertes des Modulationssignals (m) mit der Gesamtanzahl von Modulen (N), von dem die Anzahl der aktiven Module subtrahiert wird, die durch den Wert der Aktivierungsvariablen ($MOD_{ON}$) definiert ist;
sowie einen der folgenden Schritte, und zwar:
b) falls der Wert der genannten Fehlervariablen (*e*) größer als eins oder möglicherweise gleich eins ist, das Ausführen eines Einschaltalgorithmus, der Folgendes bewirkt:

     i. Aktivieren mindestens eines weiteren der genannten Module, zu einer Einschaltzeit ($T_a$), und zwar des Moduls, dessen Erkennungscode gleich einer in dem Einschaltzähler ($I_{ON}$) gespeicherten Nummer ist;
     ii. Erhöhen des Einschaltzählers um mindestens eins;
     iii. Erhöhen der Aktivierungsvariable ($MOD_{ON}$) um eine Zahl gleich der Zahl der soeben eingeschalteten Module;

c) falls der Wert der genannten Fehlervariable (*e*) kleiner als minus eins, oder möglicherweise gleich minus eins ist, das Ausführen eines Ausschaltalgorithmus, der Folgendes bewirkt:

     i. Deaktivieren mindestens eines der aktiven Module, zu einer Ausschaltzeit ($T_a$), und zwar des Moduls, dessen Erkennungscode gleich einer im Ausschaltzähler ($I_{OFF}$) gespeicherten Nummer ist;
     ii. Erhöhen des Ausschaltzählers um mindestens eins;
     iii. Verringern der Aktivierungsvariable ($MOD_{ON}$) um eine Zahl gleich der Zahl der soeben ausgeschalteten Module;

d) falls der Wert der genannten Fehlervariable (*e*) zwischen minus eins und eins liegt:

     i. Aktivieren des Moduls, dessen Erkennungscode gleich dem im Einschaltzähler ($I_{ON}$) gespeicherten ist, wenn, innerhalb eines festgelegten Zeitzyklus, eine Aktivierungszeit ($T_{on}$) verstrichen ist, die sich zumindest einer repräsentativen Dauer ($T_C$) des Zeitzyklus, multipliziert mit der Differenz zwischen eins und dem Wert der Fehlervariablen und geteilt durch zwei, annähert;

ii. Deaktivieren eines Moduls, dessen Erkennungscode gleich dem im Ausschaltzähler ($I_{OFF}$) gespeicherten ist, wenn, innerhalb eines festgelegten Zeitzyklus, eine Deaktivierungszeit ($T_{off}$) verstrichen ist, die sich zumindest einer repräsentativen Dauer des Zeitzyklus, multipliziert mit der Summe von eins und dem von der Fehlervariablen angenommenen Wert, und geteilt durch zwei, annähert;

iii. Erhöhen des Einschaltzählers ($I_{ON}$) und des Ausschaltzählers ($I_{OFF}$) um einen Wert der mindestens gleich eins ist.

2. Verfahren nach Anspruch 1, das einen Taktzähler beinhaltet, der seinen Ausgabewert zyklisch erhöht, beginnend von einem Nullwert bis hoch zu einem Auflösungswert (RES), wobei der genannte Zeitzyklus bei dem Nullwert beginnt und bei dem Auflösungswert (RES) endet; wobei die Aktivierung und/oder Deaktivierung von mindestens einem der genannten Module, aufgrund der Ausführung des Schrittes d), bei einer inkrementalen Aktualisierung des Taktzählers auf einen Wert erfolgt, der sich zumindest einer Einschaltvariablen ($I_{on}$) annähert, die definiert ist durch das Produkt der Multiplikation der Differenz zwischen eins und dem Wert der Fehlervariablen mit einer Menge, die gleich der Hälfte des Auflösungswertes (RES) ist, bzw. der sich einer Ausschaltvariablen ($I_{off}$) annähert, die definiert ist durch das Produkt der Multiplikation der Summe aus eins und dem von der Fehlervariable angenommenen Wert mit einer Menge, die gleich der Hälfte des Auflösungswertes (RES) ist.

3. Verfahren nach Anspruch 2, worin nach der Ausführung des Schrittes d) ein Modul, dessen Erkennungscode gleich dem im Einschaltzähler ($I_{ON}$) gespeicherten ist, innerhalb eines festgelegten Zeitzyklus zu einer Aktivierungszeit ($T_{on}$) aktiviert wird, die gleich einer Ganzzahl ist, die am nächsten bei einer repräsentativen Dauer des Zeitzyklus liegt, multipliziert mit dem von der Einschaltvariablen ($I_{on}$) angenommenen Wert und geteilt durch den Auflösungswert (RES).

4. Verfahren nach Anspruch 2, worin nach der Ausführung des Schrittes d) ein Modul, dessen Erkennungscode gleich dem im Ausschaltzähler ($I_{OFF}$) gespeicherten ist, innerhalb eines festgelegten Zeitzyklus zu einer Deaktivierungszeit ($T_{off}$) deaktiviert wird, die gleich der Ganzzahl ist, die am nächsten bei einem repräsentativen Wert der Dauer des Zeitzyklus liegt, multipliziert mit dem von der Ausschaltvariablen ($I_{off}$) angenommenen Wert und geteilt durch den Auflösungswert (RES).

5. Verfahren nach Anspruch 1, worin nach der Ausführung des Schrittes b) die Fehlervariable ($e$) berechnet wird und die Schritte b), d) für eine Anzahl von Malen wiederholt werden, die dem Wert der Fehlervariablen ($e$) entspricht.

6. Verfahren nach Anspruch 1, worin nach der Ausführung des Schrittes c) die Fehlervariable ($e$) berechnet wird und die Schritte c), d) für eine Anzahl von Malen wiederholt werden, die dem Wert der Fehlervariablen ($e$) entspricht.

7. Verfahren nach Anspruch 1, worin die Einschaltzeit ($T_a$) mindestens nahe dem Beginn eines nächsten Zeitzyklus liegt.

8. Verfahren nach Anspruch 1, worin die Ausschaltzeit ($T_s$) mindestens nahe dem Beginn eines nächsten Zeitzyklus liegt.

9. Verfahren nach Anspruch 1, worin der Einschaltzähler ($I_{ON}$) und der Ausschaltzähler ($I_{OFF}$) Ringzähler sind und Werte annehmen, die zwischen null und der Anzahl der genannten mehreren Module (2) minus eins liegen.

10. Verfahren nach Anspruch 1, das einen Taktzähler beinhaltet, der den Ausgabewert zyklisch erhöht, beginnend von null und bis hoch zu einem Wert, der gleich dem Auflösungswert (RES) ist, wobei jeder genannte Zeitzyklus bei dem Nullwert beginnt, während die Aktivierung und Deaktivierung von mindestens einem Modul, die während der Schritte b), c), d) erfolgt, zeitgleich mit der Aktualisierung des Wertes des Taktzählers erfolgen.

11. Verfahren nach Anspruch 1, worin mindestens ein gegebener Wert von den Werten ausgeschlossen ist, die dem Einschaltzähler ($I_{ON}$) und dem Ausschaltzähler ($I_{OFF}$) während der Betriebsbedingung zugewiesen sind, um das Deaktivieren oder Aktivieren eines Moduls zu verhindern, dessen Erkennungscode gleich diesem vorgegebenen Wert ist.

**Revendications**

1. Un procédé de modulation de tension utilisant une pluralité de modules (2) reliés en série pour établir une tension totale appliquée à une charge (3), chacun des modules étant identifié par un code d'identification et comprenant au moins une source d'alimentation ($A_j$) et des moyens de commutation ($M_j$) pour connecter ou déconnecter la source d'alimentation, activant et désactivant ainsi le module, de manière à augmenter ou à réduire respectivement la tension appliquée à ladite charge (3) d'une valeur égale à la tension ($E_j$) alimentée par la source d'alimentation ($A_j$), lesdits moyens de commutation ($M_j$)

9

étant commandés par une unité centrale (1), selon le traitement d'au moins un signal de modulation (m), le procédé étant **caractérisé en ce qu'**il comprend une phase d'initialisation destinée à mettre à zéro un compteur de mise sous tension ($I_{ON}$), un compteur de mise hors tension ($I_{OFF}$), et une variable d'activation ($MOD_{ON}$), et **en ce qu'**il répète en continu des cycles temporels, chacun desquels comprenant :

a) détection de la valeur dudit signal de modulation (m) et calcul d'une variable d'erreur (*e*) définie par la multiplication de la valeur du signal de modulation (m) par le nombre total de modules (N), de laquelle est ensuite soustrait le nombre desdits modules actifs, défini par la valeur de la variable d'activation ($MOD_{ON}$) ;
et une des phases suivantes, à savoir :
b) si la valeur de ladite variable d'erreur (*e*) est supérieure à un, ou éventuellement égale à un, un algorithme de mise sous tension est exécuté, déterminant :

i. l'activation d'au moins un autre desdits modules, à un temps de mise sous tension ($T_a$), à savoir, un module ayant un code d'identification égal à un nombre mémorisé dans le compteur de mise sous tension ($I_{ON}$) ;
ii. l'incrémentation du compteur de mise sous tension d'au moins un ;
iii. l'incrémentation de ladite variable d'activation ($MOD_{ON}$) d'un nombre égal au nombre de modules venant d'être mis sous tension ;

c) si la valeur de ladite variable d'erreur (*e*) est inférieure à moins un, ou éventuellement égale à moins un, un algorithme de mise hors tension est exécuté, déterminant :

i. la désactivation d'au moins un des modules actifs, à un temps de mise hors tension ($T_s$), à savoir, un module ayant un code d'identification égal à un nombre mémorisé dans le compteur de mise hors tension ($I_{OFF}$) ;
ii. l'incrémentation du compteur de mise hors tension d'au moins un ;
iii. la décrémentation de ladite variable d'activation ($MOD_{ON}$) d'un nombre égal au nombre des modules venant d'être mis hors tension ;

d) si la valeur de ladite variable d'erreur (*e*) est comprise entre moins un et un :

i. activation dudit module dont le code d'identification est égal à celui mémorisé dans le compteur de mise sous tension ($I_{ON}$), quand, dans les limites d'un cycle temporel prédéfini, un temps d'activation ($T_{on}$) s'est écoulé au moins proche d'une durée représentative ($T_c$) du cycle temporel, multipliée par la différence entre un et la valeur de ladite variable d'erreur divisée par deux ;
ii. désactivation d'un module dont le code d'identification est égal à celui mémorisé dans le compteur de mise hors tension ($I_{OFF}$), quand un temps de désactivation ($T_{off}$) s'est écoulé, dans les limites d'un cycle temporel prédéfini, au moins proche d'une durée représentative du cycle temporel, multipliée par la somme de un et de la valeur prise par ladite variable d'erreur divisée par deux ;
iii. incrémentation desdits compteur de mise sous tension ($I_{ON}$) et compteur de mise hors tension ($I_{OFF}$) d'une valeur égale au moins à un.

**2.** Le procédé selon la revendication 1, comprenant un compteur Clock, qui incrémente cycliquement sa valeur de sortie depuis une valeur de zéro jusqu'à une valeur de résolution (RES), avec ledit cycle temporel commençant à ladite valeur de zéro et se terminant à ladite valeur de résolution (RES) ; l'activation et/ou la désactivation d'au moins un desdits modules, due à l'exécution de ladite phase d), ayant lieu au moment d'une mise à jour incrémentielle dudit Clock au moins proche d'une variable de mise sous tension ($I_{on}$), définie par la multiplication de la différence entre un et la valeur de ladite variable d'erreur par une quantité égale à la moitié de ladite valeur de résolution (RES), et d'une variable de mise hors tension ($I_{off}$), définie par la multiplication de la somme de un et de la valeur prise par ladite variable d'erreur par une quantité égale à la moitié de la valeur de résolution (RES).

**3.** Le procédé selon la revendication 2, **caractérisé en ce que**, après l'exécution de ladite phase d), un module ayant un code d'identification égal à celui mémorisé dans le compteur de mise sous tension ($I_{ON}$) est activé, dans les limites d'un cycle temporel prédéfini, à un temps d'activation ($T_{on}$) égal à un nombre entier le plus proche d'une durée représentative du cycle temporel, multiplié par la valeur prise par ladite variable de mise sous tension ($I_{on}$), divisé par ladite valeur de résolution (RES).

**4.** Le procédé selon la revendication 2, **caractérisé en ce que**, après l'exécution de ladite phase d), un module ayant un code d'identification égal à celui mémorisé dans le compteur de mise hors tension ($I_{OFF}$)

est désactivé, dans les limites d'un cycle temporel prédéfini, à un temps de désactivation ($T_{off}$) égal à un nombre entier le plus proche d'une durée représentative du cycle temporel, multiplié par la valeur de ladite variable de mise hors tension ($I_{off}$), divisé par ladite valeur de résolution (RES).

5. Le procédé selon la revendication 1, **caractérisé en ce que**, après l'exécution de ladite phase b), ladite variable d'erreur (*e*) est calculée et lesdites phases b), d) sont répétées un certain nombre de fois selon la valeur de ladite variable d'erreur (*e*).

6. Le procédé selon la revendication 1, **caractérisé en ce que**, après l'exécution de ladite phase c), ladite variable d'erreur (*e*) est calculée et lesdites phases c), d) sont répétées un certain nombre de fois selon la valeur de ladite variable d'erreur (*e*).

7. Le procédé selon la revendication 1, **caractérisé en ce que** ledit temps de mise sous tension ($T_a$) est au moins proche du début d'un cycle temporel suivant.

8. Le procédé selon la revendication 1, **caractérisé en ce que** ledit temps de mise hors tension ($T_s$) est au moins proche du début d'un cycle temporel suivant.

9. Le procédé selon la revendication 1, **caractérisé en ce que** lesdits compteur de mise sous tension ($I_{ON}$) et compteur de mise hors tension ($I_{OFF}$) sont de type en boucle, et prennent des valeurs comprises entre zéro et le nombre de ladite pluralité de modules (2) moins un.

10. Le procédé selon la revendication 1, comprenant un compteur Clock, qui incrémente cycliquement la valeur de sortie depuis zéro jusqu'à une valeur égale à ladite valeur de résolution (RES), chaque cycle temporel commençant à la valeur zéro, tandis que l'activation et la désactivation d'au moins un module, ayant lieu pendant lesdites phases b), c), d), coïncident avec la mise à jour de la valeur du compteur Clock.

11. Le procédé selon la revendication 1, **caractérisé en ce qu'**au moins une valeur donnée est exclue des valeurs affectées auxdits compteur de mise sous tension ($I_{ON}$) et compteur de mise hors tension ($I_{OFF}$), en condition de fonctionnement, de manière à empêcher la désactivation ou l'activation d'un module ayant un code d'identification qui coïncide avec ladite valeur donnée.

# FIG. 1

**FIG 2**

START

initialization

$I_{ON}\rightarrow0$; $I_{OFF}\rightarrow0$; $MOD_{ON}\rightarrow0$

Beginning of
$T_c$ duration
generic cycle

Detection of m value;
error variable $e$ calculation

$e>1$?

yes

Waiting for end of cycle
(CK=0 condition);
Activating module with
identifying code stored in
$I_{ON}$;
incrementing $I_{ON}$,
incrementing $MOD_{ON}$;

no

$e<-1$?

yes

Waiting for end of cycle
(CK=0 condition);
Deactivating module with
identifying code stored in
$I_{OFF}$;
incrementing $I_{OFF}$,
decreasing $MOD_{ON}$

no

$I_{on}$, $I_{off}$ values are calculated,
the module having identifying code stored in
$I_{ON}$ is activated in the subsequent cycle,
when $CK\equiv I_{on}$;
the module having identifying code stored in
$I_{OFF}$ is deactivated in the subsequent cycle,
when $CK\equiv I_{off}$;
$I_{ON}$, $I_{OFF}$ are increased
End of cycle (CK=0 condition) is waited for;

FIG 3

EP 1 872 473 B1

**FIG. 4**

```
                    ┌──────────┐
                    │  START   │
                    └──────────┘
                         │
initialization   ┌──────────────────────────────────────┐
                 │ I_ON→0; I_OFF→0; MOD_ON→0; i→1;       │
                 └──────────────────────────────────────┘
```

CK=0 is waited for

CK=0 is waited for

Start of iT_c-th cycle

i→i+1; SR→Slew Rate Detection of m value; error variable e calculation

e>1?

yes — In subsequent cycle (i+1)T_c, when CK=0, module with identifying code stored in I_ON is activated; I_ON is increased; MOD_ON is increased

no

e<-1?

yes — In subsequent cycle (i+1)T_c, when CK=0, module with identifying code stored in I_OFF is deactivated; I_OFF is increased; MOD_OFF is decreased

no

SR=E_j/T_c ?

yes

no — SR→SR- E_j/T_c error variable calculation

e<-1?

yes

no

SR=E_j/T_c ?

yes

no — SR→SR- E_j/T_c error variable calculation

e>1?

no

yes

I_on, I_off values are calculated in the subsequent cycle (i+1)T_c,, when CK≡I_on the module having identifying code stored in I_ON is activated;
in the subsequent cycle (i+1)T_c,, when CK≡I_off, the module having identifying code stored in I_OFF is deactivated;
ION, IOFF are increased
CK=0 condition is waited for.

**FIG. 5**

EP 1 872 473 B1

**EP 1 872 473 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0124765 A
- EP 0329967 A
- EP 0690560 A
- US 2004109512 A